# EUROPEAN PATENT SPECIFICATION

(11) **EP 4 576 318 B1**
(45) Date of publication and mention of the grant of the patent: **09.12.2026**
(21) Application number: 24852112.2
(22) Date of filing: 18.07.2024
(51) Int. Cl.: H01M 10/42, G01B 21/08, H01M 4/38, H01M 4/48, H01M 4/36, H01M 10/052, H01M 50/105, H01M 4/02, G01B 5/06, G01B 11/06, H01M 10/48, H01M 4/587, G01R 31/392

(54) **SECONDARY BATTERY DIAGNOSING APPARATUS AND METHOD**
SEKUNDÄRBATTERIEDIAGNOSEAPPARAT UND -VERFAHREN
APPAREIL ET PROCÉDÉ DE DIAGNOSTIC DE BATTERIE RECHARGEABLE

(30) Priority: 09.08.2023 KR 20230104441
(43) Date of publication of application: 25.06.2025
(73) Proprietor: LG Energy Solution, Ltd., Seoul 07335 (KR)
(72) Inventor: LEE, Ji-Eun, Daejeon 34122 (KR)
(74) Representative: Goddar, Heinz J.
(86) International application number: PCT/KR2024/010346
(87) International publication number: WO 2025/033756

(56) References cited:
- WO-A1-2024/188561
- KR-A- 20150 117 316
- KR-A- 20170 009 995
- KR-A- 20170 009 995
- KR-A- 20170 082 262
- KR-A- 20190 118 536
- KR-A- 20190 129 754
- KR-A- 20230 096 930

## Description

### TECHNICAL FIELD

This application is based on and claims priority from Korean Patent Application No. 10-2023-0104441, filed on August 9, 2023, with the Korean Intellectual Property Office.

The present disclosure relates to a secondary battery diagnosing apparatus and method, and more specifically, to a secondary battery diagnosing apparatus and method for diagnosing the state of a secondary battery to which a negative electrode active material including silicon or silicon oxide is applied.

### BACKGROUND ART

In general, a secondary battery refers to a battery that may be repeatedly charged and discharged. Types of such secondary batteries include lithium secondary batteries that use lithium ions, such as lithium-ion batteries or lithium-ion polymer batteries, nickel cadmium batteries, nickel hydrogen batteries, nickel zinc batteries, and so on.

Recently, as secondary batteries are applied to various devices that require high output voltage and large charging capacity, such as electric vehicles and ESSs (Energy Storage Systems), lithium secondary batteries are being widely used because they have the advantages of almost no memory effect, low self-discharge rate, and high energy density compared to secondary batteries using nickel.

As these secondary batteries undergo repeated charging and discharging cycles, they no longer maintain the electrical capacity at the time of manufacture and gradually deteriorate. If the current state of these secondary batteries is not accurately diagnosed, it becomes difficult to measure or predict SoC (State of Charge), usable time, remaining lifespan, and replacement time of the secondary battery, which results in unexpected damage to the user of the secondary battery.

However, existing technologies have the problem that diagnosing the secondary battery requires a lot of cost and has a high possibility of errors in the diagnosis results because they measure various electrical factors such as voltage, current, and resistance of the secondary battery and diagnose the state of the secondary battery by substituting the measured values into a complex formula.

In particular, existing technologies have a problem in that they cannot provide a method to efficiently and accurately diagnose the state of a secondary battery that uses a negative electrode active material containing silicon or silicon oxide to increase energy density.
KR 2019 0129754 A discloses a method for diagnosing a lithium ion battery, comprising at least: acquiring first information in which a charge capacity of a lithium ion battery and an index value are related; using the first information, expressing the index value as a function of the charge capacity and calculating an extremum point where the second derivative of the function takes a minimum value; and diagnosing the lithium battery using the charge capacity of the extremum point, wherein the lithium ion battery includes at least silicon oxide and graphite in a negative electrode, the index value is measurable from the outside of the lithium ion battery, and the index value reflects a volume of the silicon oxide and the graphite.
KR 2017 0009995 A discloses a deterioration diagnosis system for a sealed secondary battery, characterized in that it comprises a detection sensor that detects deformation of the sealed secondary battery, a control device that obtains a first curve representing a relationship between a discharge capacity from a fully charged state or a charge capacity up to a fully charged state and an amount of deformation of the sealed secondary battery detected by the detection sensor, and a second curve representing a relationship between the charge/discharge capacity and the slope of the first curve, calculates a charge/discharge capacity Qc between stage change points that appear as extreme values in the second curve, and calculates a maintenance rate of an active material according to a ratio Qc/Qs of the charge/discharge capacity Qc to the charge/discharge capacity Qs between stage points from a predetermined reference state.
WO 2024/188561 A1 discloses a method to determine aging of a battery cell, wherein a cell thickness change of the battery single cell is acquired via a charging state (SOC), characterized in that a curve of cell thickness change is analyzed over the charging state (SOC) during charging and discharging of the respective battery single cell to derive, based on characteristic properties of the curve, a contribution of at least one of the active materials to the cell thickness change and thereby to aging. WO 2024/188561 A1 falls under Article 54(3) EPC.

### DISCLOSURE

### Technical Problem

A technical challenge that the present disclosure seeks to solve is to provide a secondary battery diagnosing apparatus and method that efficiently and accurately diagnoses the state of a secondary battery to which a negative electrode active material including silicon or silicon oxide is applied.

Another technical challenge that the present disclosure seeks to solve is to provide a battery pack and vehicle that efficiently and accurately diagnose the state of a secondary battery to which a negative electrode active material including silicon or silicon oxide is applied.

### Technical Solution

The invention is set out in the appended claims. A secondary battery diagnosing apparatus according to one aspect of the present disclosure diagnoses a state of a secondary battery to which a negative electrode active material containing silicon or silicon oxide is applied, and comprises: a thickness sensor configured to sense a thickness change of the secondary battery according to a volume change of the negative electrode active material while the secondary battery is being charged or discharged; and a processor configured to estimate a capacity ratio, which is a ratio of a capacity provided by the silicon or the silicon oxide to a capacity of the secondary battery provided by the negative electrode active material, using the sensing result of the thickness sensor, and diagnose the state of the secondary battery based on the capacity ratio.

In an embodiment, the thickness sensor may be configured to sense the thickness change of the secondary battery by measuring a distance from a predetermined location to a surface of the secondary battery.

The processor is configured to, before estimating the capacity ratio, generate a first profile representing a thickness of the secondary battery that changes over time or according to a charging state change of the secondary battery and a second profile representing a slope of the first profile that changes over time or according to the charging state change of the secondary battery using the sensing result of the thickness sensor, and estimate the capacity ratio based on the second profile.

The processor is configured to divide the second profile into a plurality of sections, select a target section related to the silicon or the silicon oxide among the plurality of sections, and estimate the capacity ratio by comparing a total length of the plurality of sections along a first axis direction with a length of the target section along the first axis direction.

The processor is configured to divide the second profile into the plurality of sections according to a slope change trend of the first profile shown in the second profile.

The processor is configured to select a section, in which a charging state of the secondary battery is within a range below a predetermined threshold and in which a slope change trend of the first profile is different from that of other sections, among the plurality of sections as the target section.

The thickness sensor is configured to sense the thickness change of the secondary battery while the secondary battery is being discharged, and the processor is configured to select a section, in which a slope change trend of the first profile is changed from a decreasing trend to an increasing trend, among the plurality of sections as the target section.

In an embodiment, the processor may be configured to, before diagnosing the state of the secondary battery, further estimate a weight ratio, which is a ratio of a weight of the silicon or the silicon oxide to a total weight of the negative electrode active material, and compare the capacity ratio with a reference capacity ratio corresponding to the weight ratio to diagnose the state of the secondary battery.

In an embodiment, the processor may be configured to estimate the weight ratio before the number of charging cycles or discharging cycles of the secondary battery exceeds a predetermined number.

In an embodiment, the processor may be configured to repeatedly estimate the capacity ratio while a charging cycle or a discharging cycle of the secondary battery is repeated, and diagnose the state of the secondary battery based on a change trend of the estimated capacity ratios.

In an embodiment, the negative electrode active material may contain a mixture in which the silicon or the silicon oxide is mixed with graphite.

In an embodiment, the secondary battery may be a pouch-type secondary battery.

A secondary battery diagnosing method according to another aspect of the present disclosure diagnoses a state of a secondary battery to which a negative electrode active material containing silicon or silicon oxide is applied, and comprises: an A step of, by a thickness sensor, sensing a thickness change of the secondary battery according to a volume change of the negative electrode active material while the secondary battery is being charged or discharged; a B step of, by a processor, estimating a capacity ratio, which is a ratio of a capacity provided by the silicon or the silicon oxide to a capacity of the secondary battery provided by the negative electrode active material, using the sensing result of the thickness sensor; and a C step of, by the processor, diagnosing the state of the secondary battery based on the capacity ratio.

The B step includes a B1 step of generating a first profile representing a thickness of the secondary battery that changes over time or according to a charging state change of the secondary battery using the sensing result of the thickness sensor; a B2 step of generating a second profile representing a slope of the first profile that changes over time or according to the charging state change of the secondary battery based on the first profile; and a B3 step of estimating the capacity ratio based on the second profile.

The B3 step includes dividing the second profile into a plurality of sections according to a slope change trend of the first profile shown in the second profile, select a section, in which a charging state of the secondary battery is within a range below a predetermined threshold and in which a slope change trend of the first profile is different from that of other sections, among the plurality of sections as the target section, and estimating the capacity ratio by comparing a total length of the plurality of sections along a first axis direction with a length of the target section along the first axis direction.

A battery pack according to still another, not claimed, aspect of the present disclosure may comprise the above-mentioned secondary battery diagnosing apparatus.

A vehicle according to still another, not claimed, aspect of the present disclosure may comprise the above-mentioned secondary battery diagnosing apparatus.

### Advantageous Effects

According to the present disclosure, while a secondary battery to which a negative electrode active material including silicon or silicon oxide is applied is being charged or discharged, a thickness sensor senses a thickness change of the secondary battery according to a volume change of the negative electrode active material, and a processor estimates a capacity ratio, which is a ratio of an electrical capacity provided by silicon oxide to an electrical capacity provided by the negative electrode active material of the secondary battery, by using the sensing result of the thickness sensor regarding the thickness change of the secondary battery, and diagnoses the state of the secondary battery based on this capacity ratio, thereby efficiently and accurately diagnosing the state of the secondary battery to which a negative electrode active material including silicon or silicon oxide is applied.

In addition, before the processor estimates the capacity ratio, the processor sequentially generates a first profile representing the thickness of the secondary battery that changes over time or according to the charging state change of the secondary battery, and a second profile representing the slope of the first profile that changes over time or according to the charging state change of the secondary battery, using the sensing result of the thickness sensor, and estimates the capacity ratio based on this second profile, thereby diagnosing the state of the secondary battery in a simplified manner independent of electrical factors of the secondary battery.

In addition, the processor divides the second profile into a plurality of sections, selects a target section that exhibits unique characteristics of silicon or silicon oxide from the plurality of sections, and estimates the capacity ratio by comparing the length of the entire plurality of sections along a first axis direction with the length of the target section along the first axis direction, thereby reducing the amount of computation required to diagnose the state of the secondary battery, and as a result, improving the speed of diagnosing the secondary battery.

In addition, the processor estimates the weight ratio, which is a ratio of the weight of silicon or silicon oxide to the total weight of the negative electrode active material, and compares the capacity ratio with a reference capacity ratio corresponding to the estimated weight ratio to diagnose the state of the secondary battery, thereby diagnosing the state of the target secondary battery even when the weight ratio of silicon or silicon oxide included in the negative electrode active material of the target secondary battery is unknown.

In addition, since the thickness sensor for sensing the thickness change of the secondary battery is configured to sense the thickness change of the corresponding secondary battery by measuring the distance from a predetermined location to the surface of the secondary battery, it is possible not only to sense the thickness change of the secondary battery for each secondary battery, but also sense the entire thickness change of the secondary battery module by regarding a plurality of secondary batteries stacked in the thickness direction as one secondary battery module. That is, the secondary battery diagnosing apparatus according to the present disclosure may be included in a battery pack or vehicle having a plurality of secondary batteries, and may diagnose the states of the plurality of secondary batteries in units of secondary battery modules.

Furthermore, a person having ordinary skill in the art to which the present disclosure belongs will be able to clearly understand from the following description that various embodiments according to the present disclosure can solve various technical problems not mentioned above.

### DESCRIPTION OF DRAWINGS

FIG. 1 is a block diagram showing a secondary battery diagnosing apparatus according to an embodiment of the present disclosure.
FIG. 2 is an exploded perspective view showing an example of a secondary battery.
FIG. 3 is a front view showing the secondary battery illustrated in FIG. 2.
FIG. 4 is a profile showing the thickness change during charging and discharging of a secondary battery.
FIG. 5 is a drawing showing a first profile and a second profile of a secondary battery to which a negative electrode active material not containing silicon oxide is applied.
FIG. 6 is a drawing showing the first profile and the second profile of a first secondary battery to which a negative electrode active material containing silicon oxide at a weight ratio of 3% is applied.
FIG. 7 is a drawing showing the first profile and the second profile of a second secondary battery to which a negative electrode active material containing silicon oxide at a weight ratio of 5% is applied.
FIG. 8 is a drawing showing the first profile and the second profile of a third secondary battery to which a negative electrode active material containing silicon oxide at a weight ratio of 10% is applied.
FIG. 9 is a graph showing the thickness change during charging and discharging of a secondary battery according to the number of charging and discharging cycles of the secondary battery.
FIG. 10 is a drawing showing the second profile in which the thickness of the secondary battery is differentiated with respect to time during discharging.
FIG. 11 is a drawing showing the second profile in which the thickness of the secondary battery is differentiated with respect to time during discharging, according to the number of discharging cycles of the corresponding secondary battery.
FIG. 12 is a flow chart showing a secondary battery diagnosing method according to an embodiment of the present disclosure.
FIG. 13 is a flow chart showing a capacity ratio estimation process of the secondary battery diagnosing method according to an embodiment of the present disclosure.
FIG. 14 is a drawing showing a vehicle according to an embodiment of the present disclosure.

### BEST MODE

Hereinafter, in order to clarify the solution corresponding to the technical challenge of the present disclosure, embodiments according to the present disclosure will be described in detail with reference to the attached drawings. However, when explaining the present disclosure, if a description of a related publicly known technology obscures the gist of the present disclosure, the description thereof may be omitted.

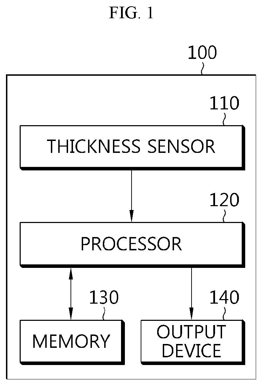

FIG. 1 is a block diagram showing a secondary battery diagnosing apparatus 100 according to an embodiment of the present disclosure.

As illustrated in FIG. 1, the secondary battery diagnosing apparatus 100 according to an embodiment of the present disclosure is configured to diagnose a state of a secondary battery to which a negative electrode active material containing silicon or silicon oxide is applied. To this end, the secondary battery diagnosing apparatus 100 includes a thickness sensor 110 and a processor 120.

The thickness sensor 110 is configured to sense a thickness change of the secondary battery according to a volume change of the negative electrode active material applied to the secondary battery while the secondary battery is being charged or discharged.

The processor 120 is configured to estimate a capacity ratio of silicon or silicon oxide contained in the negative electrode active material using the sensing result of the thickness sensor 110, and to diagnose the state of the secondary battery based on the capacity ratio. Here, the capacity ratio means a ratio of the capacity provided by the silicon or the silicon oxide to the capacity of the secondary battery provided by the negative electrode active material.

In an embodiment, the thickness sensor 110 may be configured to sense a thickness change of the secondary battery by measuring a distance from a predetermined location to a surface of the secondary battery. In this case, the thickness sensor 110 may be configured as a contact sensor such as a micrometer, or a non-contact sensor such as a displacement sensor using a laser or light.

Also, in an embodiment, the secondary battery diagnosing apparatus 100 may further include a memory 130. In this case, the memory 130 may be configured to transfer previously stored data to the processor 120 or to store data transferred from the processor 120.

For example, the memory 130 may be configured to store data regarding a reference capacity ratio that should be provided by silicon or silicon oxide included in the negative electrode active material of a normal secondary battery. In this case, the memory 130 may store data regarding the reference capacity ratio for each weight ratio of silicon or silicon oxide included in the negative electrode active material. In addition, the memory 130 may be configured to further store data regarding the capacity ratio of silicon or silicon oxide estimated by the processor 120 and data regarding the secondary battery diagnosis result.

The memory 130 may include at least one of RAM (Random Access Memory), SRAM (Static RAM), ROM (Read Only Memory), EEPROM (Electrically Erasable Programmable Read Only Memory), PROM (Programmable Read Only Memory), flash memory, hard disk, SSD (Solid State Disk), and SDD (Solid Disk Drive).

Also, in an embodiment, the secondary battery diagnosing apparatus 100 may further include an output device 140. In this case, the output device 140 may be configured to output data or information through visual, auditory or audiovisual means. To this end, the output device 140 may optionally include a visual display device such as a display, a light-emitting diode, or the like, and an audio device such as a speaker.

For example, if the secondary battery diagnosis result indicates that the state of the secondary battery is bad, the processor 120 may control the output device 140 to output a predetermined alarm.

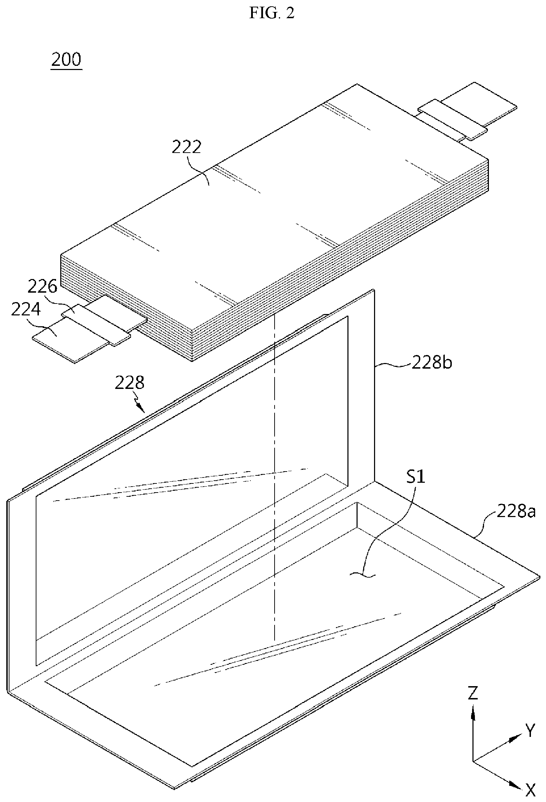

FIG. 2 is an exploded perspective view showing an example of a secondary battery 200.

As illustrated in FIG. 2, the secondary battery 200 may include an electrode assembly 222 in which a positive electrode and a negative electrode are stacked on each other with a separator therebetween, and a case 228 that accommodates the electrode assembly 222 together with an electrolyte material in an inner space S1.

In addition, the secondary battery 200 may further include an electrode lead 224 electrically connected to the electrode assembly 222, and a sealing tape 226 sealing a periphery of the electrode lead 224.

The case 228 of the secondary battery 200 may include a first case portion 228a and a second case portion 228b that are mutually coupled to form an inner space S1. The case 228 may be sealed by hermetically coupling a rim portion of the first case portion 228a and a rim portion of the second case portion 228b to each other in a state where the electrode assembly 222 is accommodated in the inner space S1.

The positive electrode forming the electrode assembly 222 of the secondary battery 200 may include a positive electrode substrate made of a material including aluminum, and a positive electrode active material applied to the positive electrode substrate. The positive electrode active material may contain lithium oxide. The positive electrode active material may be applied to the positive electrode substrate together with a conductive material, a binder, and the like.

The negative electrode of the electrode assembly 222 may include a negative electrode substrate made of a material including copper, and a negative electrode active material applied to the negative electrode substrate. The negative electrode active material may contain a silicon-based material such as silicon (Si) or silicon oxide (SiOₓ), and graphite. That is, the negative electrode active material may include a mixture in which the silicon-based material and graphite are each blended at a predetermined weight ratio. The negative electrode active material may be applied to the negative electrode substrate together with a conductive material, a binder, and the like.

In this way, by containing silicon or silicon oxide in the negative electrode active material of the secondary battery, the electrical capacity provided by the negative electrode active material of the same weight may be increased, and as a result, the energy density of the secondary battery may be increased.

Meanwhile, silicon-based materials such as silicon (Si) or silicon oxide (SiOx) have unique characteristics of high reaction potential and large volume change due to electrochemical reaction compared to graphite, which is blended with silicon-based materials.

Therefore, the secondary battery diagnosing apparatus 100 according to the present disclosure diagnoses the state of the secondary battery, such as the deterioration state, capacity loss rate, and remaining lifespan, by utilizing the unique characteristics of silicon-based materials.

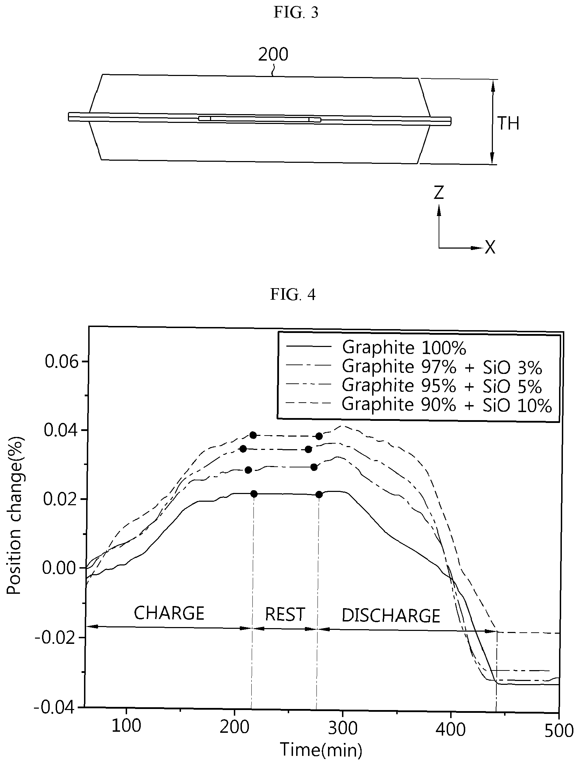

FIG. 3 is a front view showing the secondary battery 200 illustrated in FIG. 2.

As illustrated in FIG. 3, the manufactured secondary battery 200 may have a predetermined thickness (TH). In this case, the thickness (TH) of the secondary battery 200 may correspond to the thickness of the electrode assembly accommodated inside the secondary battery 200.

The thickness (TH) of the secondary battery 200 changes along with the volume change of the negative electrode active material that occurs during charging or discharging of the secondary battery 200.

The secondary battery diagnosing apparatus 100 according to the present disclosure diagnoses the state of the secondary battery by sensing the thickness change of the secondary battery.

In addition, the secondary battery that becomes a diagnosis target of the secondary battery diagnosing apparatus 100 according to the present disclosure may be configured in various forms in which the thickness in a specific direction changes according to the volume change of the negative electrode active material during charging or discharging.

For example, as illustrated in FIGS. 2 and 3, the secondary battery that is the diagnosis target of the secondary battery diagnosing apparatus 100 according to the present disclosure may be configured as a pouch-type secondary battery. According to an embodiment, the secondary battery that is the diagnosis target of the secondary battery diagnosing apparatus 100 according to the present disclosure may also be configured as a secondary battery of another shape in which the thickness of a specific portion changes according to a volume change of a negative electrode active material, such as a square secondary battery or a cylindrical secondary battery.

FIG. 4 is a profile showing the thickness change during charging and discharging of a secondary battery.

In FIG. 4, the horizontal axis represents the time elapsed after the start of the charging/discharging cycle, and the vertical axis represents the ratio of the surface position change value to the original thickness value of the secondary battery.

As illustrated in FIG. 4, the thickness change during charging and discharging of the secondary battery may vary depending on the weight ratio of silicon or silicon oxide included in the negative electrode active material of the secondary battery. Here, the weight ratio refers to a ratio of the weight of silicon or silicon oxide to the total weight of the negative electrode active material.

That is, during charging, resting, and discharging, a secondary battery including SiO, which is a type of silicon oxide, in the negative electrode active material exhibits a larger volume change than a secondary battery that does not include SiO.

In addition, among secondary batteries including silicon oxide in the negative electrode active material, a secondary battery including silicon oxide with a relatively large weight ratio (10%) shows a larger volume change than a secondary battery including silicon oxide with a relatively small weight ratio (3% or 5%).

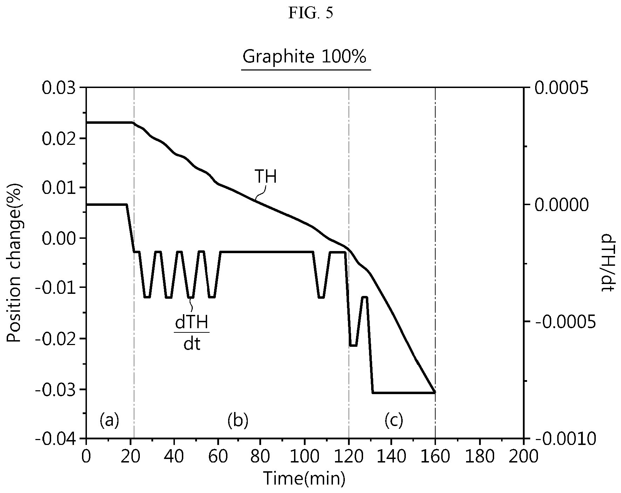

FIG. 5 is a drawing showing a first profile (TH) and a second profile (dTH/dt) of a secondary battery to which a negative electrode active material not containing silicon oxide is applied.

In FIG. 5, the horizontal axis represents the time elapsed after the start of the discharging cycle, the left vertical axis represents the ratio of the surface position change value to the original thickness value of the secondary battery, and the right vertical axis represents the slope of the first profile (TH).

In addition, the first profile (TH) represents the thickness of the secondary battery, which changes over time or according to the charging state change of the secondary battery during the discharging cycle of the secondary battery to which the negative electrode active material containing graphite at a weight ratio of 100% is applied. In addition, the second profile (dTH/dt) represents the slope of the first profile (TH), which changes over time or according to the charging state change of the secondary battery. In this case, the second profile (dTH/dt) may be obtained by differentiating the first profile (TH) with respect to time (t).

As shown in FIG. 5, the first profile (TH) of the secondary battery shows that the thickness of the secondary battery gradually decreases during discharge.

In addition, the second profile (dTH/dt) of the secondary battery shows that the slope of the first profile (TH) gradually decreases as the discharge progresses.

That is, the second profile (dTH/dt) is divided into a plurality of sections (a, b, c). In this case, an increase or decrease in the slope may occur within each section, but the slope of each section tends to gradually decrease as it goes from the first section (a), which corresponds to the early stage of discharging, to the third section (c), which corresponds to the late stage of discharging.

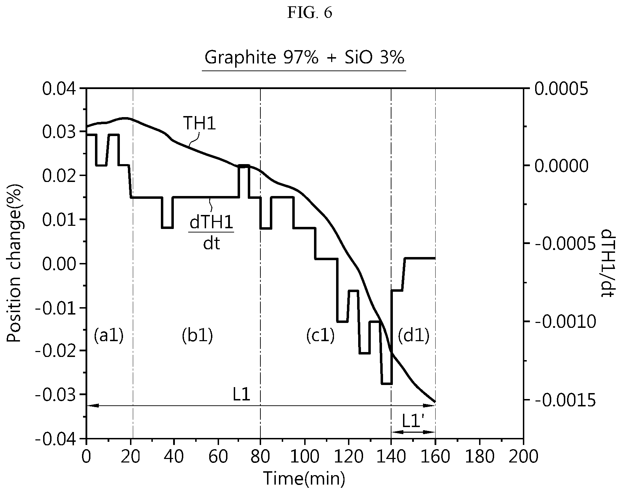

FIG. 6 is a drawing showing the first profile (TH1) and the second profile (dTH1/dt) of a first secondary battery to which a negative electrode active material containing silicon oxide at a weight ratio of 3% is applied.

In FIG. 6, the horizontal axis represents the time elapsed after the start of the discharging cycle, the left vertical axis represents the ratio of the surface location change value to the original thickness value of the first secondary battery, and the right vertical axis represents the slope of the first profile (TH1). Depending on the embodiment, the horizontal axis may also represent the SoC (State of Charge) of the first secondary battery.

As shown in FIG. 6, the negative electrode active material of the first secondary battery may contain a mixture of silicon or silicon oxide and graphite.

In addition, the first profile (TH1) of the first secondary battery to which the negative electrode active material containing graphite and SiO at weight ratios of 97% and 3%, respectively, is applied shows the thickness of the first secondary battery that changes over time or according to the charging state change of the first secondary battery during the discharging cycle of the first secondary battery.

In addition, the second profile (dTH1/dt) of the first secondary battery represents the slope of the first profile (TH1) that changes over time or according to the charging state change of the first secondary battery. In this case, the second profile (dTH1/dt) may be obtained by differentiating the first profile (TH1) with respect to time (t).

The first profile (TH1) of the first secondary battery shows that the thickness of the first secondary battery gradually decreases while the first secondary battery is being discharged.

However, the second profile (dTH1/dt) of the first secondary battery shows that the slope of the first profile (TH1) gradually decreases while the first secondary battery is being discharged, and then increases again at a certain point.

That is, the second profile (dTH1/dt) is divided into a plurality of sections (a1, b1, c1, d1). In this case, the slope of each section gradually decreases as it goes from the first section (a1) corresponding to the early stage of discharging to the second section (b1) and the third section (c1) corresponding to the middle stage of discharging, but in the fourth section (d1) corresponding to the end of discharging, the slope changes to an increasing trend.

This phenomenon is due to the unique characteristics of silicon or silicon oxide that occur when the SoC (State of Charge) of the secondary battery is relatively low, because the reaction potential of silicon or silicon oxide is relatively higher than that of graphite.

Therefore, the secondary battery diagnosing apparatus 100 according to the present disclosure diagnoses the state of the secondary battery, such as the degree of deterioration, capacity loss rate, and remaining lifespan, by utilizing the unique characteristics of silicon or silicon oxide.

That is, the processor 120 of the secondary battery diagnosing apparatus 100 estimates the capacity ratio of silicon or silicon oxide by using the sensing result of the thickness sensor 110 that senses the thickness change of the secondary battery during discharging, and diagnoses the state of the secondary battery based on the capacity ratio.

As mentioned above, the capacity ratio refers to the ratio occupied by the capacity provided by silicon or silicon oxide to the capacity of the secondary battery provided by the negative electrode active material.

For example, the thickness sensor 110 senses a thickness change of the first secondary battery while the first secondary battery is being discharged.

In addition, by using the sensing result of the thickness sensor 110, the processor 120 generates a first profile (TH1) representing the thickness of the first secondary battery that changes over time or according to the charging state change, as illustrated in FIG. 6, and a second profile (dTH1/dt) representing the slope of the first profile (TH1) that changes over time or according to the charging state change of the first secondary battery, and estimate the capacity ratio of SiO corresponding to silicon oxide based on the second profile (dTH1/dt).

Specifically, the processor 120 divides the second profile (dTH1/dt) into a plurality of sections (a1, b1, c1, d1) and selects a target section related to silicon or silicon oxide among these plurality of sections (a1, b1, c1, d1).

In this case, the processor 120 divides the second profile (dTH1/dt) into a plurality of sections (a1, b1, c1, d1) according to the slope change trend of the first profile (TH1) shown in the second profile (dTH1/dt). In FIG. 6, the second profile (dTH1/dt) is divided into four sections, but it may also be divided into two sections. That is, the second profile (dTH1/dt) may be divided into a first section (a1, b1, c1) in which the slope change trend of the first profile (TH1) is a decreasing trend, and a second section (d1) in which the slope change trend is an increasing trend.

In addition, the processor 120 selects the target section as a section in which the charging state of the first secondary battery is within a range below a predetermined threshold and in which the slope change trend of the first profile (TH1) is different from that of other sections among the plurality of sections (a1, b1, c1, d1).

For example, when the thickness sensor 110 senses the thickness change of the first secondary battery while the first secondary battery is being discharged, the processor 120 selects a section (d1) in which the slope change trend of the first profile (TH1) has changed from a decreasing trend to an increasing trend as the target section among the plurality of sections (a1, b1, c1, d1).

In this case, the processor 120 may select the fourth section (d1), which is a section in which the SoC of the first secondary battery is less than or equal to 50% and in which the slope change trend of the first profile (TH1) is an increasing trend, unlike the first to third sections (a1, b1, c1), as the target section among the first to fourth sections (a1, b1, c1, d1).

The reason why the target section is selected in the range where the charging state of the secondary battery is below a predetermined threshold is that, in the case of a secondary battery using nickel as a positive electrode material, a section in which the slope of the first profile (TH1) temporarily increases appears even in the late charging stage or early discharging stage when the SoC of the secondary battery is high, and silicon or silicon oxide acts in the early charging stage or late discharging stage when the SoC of the secondary battery is relatively low.

When a target section is selected as described above, the processor 120 estimates the capacity ratio of silicon or silicon oxide by comparing the total length (L1) of the plurality of sections (a1, b1, c1, d1) along the first axis (horizontal axis) direction representing time or charging state (SoC) with the length (L1') of the target section along the first axis (horizontal axis) direction.

For example, the capacity ratio may be calculated as in the formula 1. [Formula 1] $CR = k \left({L}_{t}/{L}_{p}\right) \times 100 \left[%\right]$

In the formula 1, CR is the capacity ratio of silicon or silicon oxide, Lₚ is the total length of the second profile, Lt is the length of the target section, and k is a predetermined proportional constant. Therefore, the capacity ratio CR1 of SiO in FIG. 6 may be calculated as k(L1'/L1) × 100 [%].

When the capacity ratio is estimated in this way, the processor 120 diagnoses the state of the first secondary battery using the estimated capacity ratio. For example, the processor 120 may diagnose the state of the first secondary battery by comparing the estimated capacity ratio with a reference capacity ratio of silicon or silicon oxide obtained in advance from a normal secondary battery.

In an embodiment, the secondary battery diagnosing apparatus 100 according to the present disclosure may be configured to pre-store reference capacity ratio information of a diagnosis target secondary battery in the memory 130. The reference capacity ratio information may include information indicating a reference capacity ratio corresponding to a predetermined number of charging cycles or a predetermined number of discharging cycles of the diagnosis target secondary battery. In this case, the processor 120 may diagnose the state of the first secondary battery by comparing the capacity ratio estimated with respect to the first secondary battery with the reference capacity ratio of the first secondary battery pre-stored in the memory 130.

In another embodiment, the processor 120 may be configured to further estimate a weight ratio, which is a ratio of the weight of silicon or silicon oxide to the total weight of the negative electrode active material, before diagnosing the state of the diagnosis target secondary battery, and compare the estimated capacity ratio with a reference capacity ratio corresponding to the weight ratio to diagnose the state of the diagnosis target secondary battery.

In this case, the processor 120 may estimate the weight ratio before the number of charging cycles or discharging cycles of the diagnosis target secondary battery exceeds a predetermined number.

For example, the processor 120 may estimate the capacity ratio of silicon oxide after the end of a discharging cycle that has occurred before degradation of the diagnosis target secondary battery occurs, and estimate the weight ratio of silicon oxide corresponding to the estimated capacity ratio.

Table 1 shows the capacity ratio corresponding to the weight ratio of SiO included in the negative electrode active material.

**[Table 1]**

| | **weight ratio (%)** | | **capacity ratio (%)** | |
|---|---|---|---|---|
| | **graphite** | **SiO** | **graphite** | **SiO** |
| **CASE 1** | 97 | 3 | 89.8 | 10.2 |
| **CASE 2** | 95 | 5 | 83.7 | 16.3 |
| **CASE 3** | 90 | 10 | 70.9 | 29.1 |

As shown in Table 1, silicon oxide included in the negative electrode active material has a high capacity ratio compared to its weight ratio. Therefore, by including silicon or silicon oxide in the negative electrode active material of the secondary battery, the energy density of the secondary battery may be improved. In this way, since the weight ratio and capacity ratio of silicon or silicon oxide are correlated, if one of the two is estimated, the other can also be estimated.

Therefore, the processor 120 may estimate the capacity ratio of silicon or silicon oxide included in the negative electrode active material of the diagnosis target secondary battery at the beginning of use of the diagnosis target secondary battery, and estimate the weight ratio of the silicon or silicon oxide through the estimated capacity ratio.

Next, the processor 120 may obtain reference capacity ratio information corresponding to the estimated weight ratio among the reference capacity ratio information for each weight ratio pre-stored in the memory 130.

Afterwards, the processor 120 may diagnose the state of the diagnosis target secondary battery by comparing the obtained reference capacity ratio information with the capacity ratio of silicon or silicon oxide repeatedly estimated in relation to the diagnosis target secondary battery.

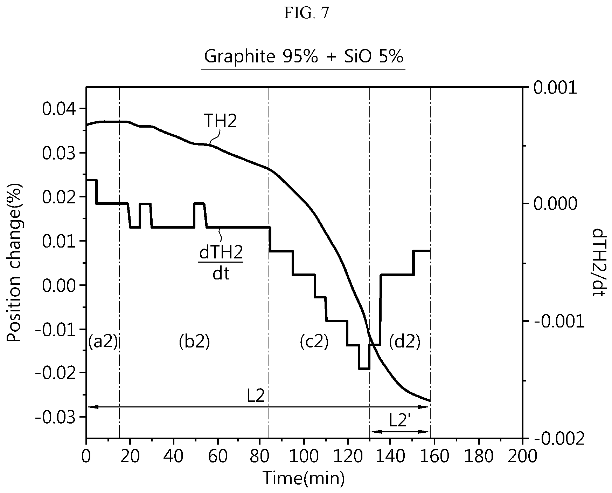

FIG. 7 is a drawing showing the first profile and the second profile of a second secondary battery to which a negative electrode active material containing silicon oxide at a weight ratio of 5% is applied.

In FIG. 7, the horizontal axis represents the time elapsed after the start of the discharging cycle, the left vertical axis represents the ratio of the surface location change value to the original thickness value of the second secondary battery, and the right vertical axis represents the slope of the first profile (TH2). Depending on the embodiment, the horizontal axis may also represent the SoC (State of Charge) of the second secondary battery.

As shown in FIG. 7, the first profile (TH2) of the second secondary battery to which the negative electrode active material containing graphite and SiO at weight ratios of 95% and 5%, respectively, is applied shows the thickness of the second secondary battery that changes over time or according to the charging state change of the second secondary battery during the discharging cycle of the second secondary battery.

In addition, the second profile (dTH2/dt) of the second secondary battery represents the slope of the first profile (TH2) that changes over time or according to the charging state change of the second secondary battery. In this case, the second profile (dTH2/dt) may be obtained by differentiating the first profile (TH2) with respect to time (t).

The first profile (TH2) of the second secondary battery shows that the thickness of the second secondary battery gradually decreases during the discharge of the second secondary battery.

However, the second profile (dTH2/dt) of the second secondary battery shows that the slope of the first profile (TH2) gradually decreases while the discharge of the second secondary battery progresses, and then increases again at a certain point.

That is, the second profile (dTH2/dt) is divided into a plurality of sections (a2, b2, c2, d2). In this case, the slope of each section gradually decreases as it goes from the first section (a2), which corresponds to the early stage of discharging, to the second section (b2) and the third section (c2), which correspond to the middle stage of discharging, but in the fourth section (d2), which corresponds to the end of discharging, the slope changes to an increasing trend.

Therefore, the processor 120 of the secondary battery diagnosing apparatus 100 according to the present disclosure estimates the capacity ratio of silicon or silicon oxide using the sensing result of the thickness sensor 110 that senses the thickness change of the secondary battery during discharging, as described with reference to FIG 6, and diagnoses the state of the secondary battery based on the capacity ratio.

That is, the thickness sensor 110 senses the thickness change of the second secondary battery while the second secondary battery is being discharged.

In addition, the processor 120 generates a first profile (TH2) representing the thickness of the second secondary battery that changes over time or according to the charging state change of the second secondary battery and a second profile (dTH2/dt) representing the slope of the first profile (TH2) that changes over time or according to the charging state change of the second secondary battery, using the sensing result of the thickness sensor 110, and may estimate the capacity ratio of SiO corresponding to silicon oxide based on the second profile (dTH2/dt).

To this end, the processor 120 divides the second profile (dTH2/dt) into a plurality of sections (a2, b2, c2, d2), and select a target section related to silicon or silicon oxide among these plurality of sections (a2, b2, c2, d2).

For example, the processor 120 may divide the second profile (dTH2/dt) into first to fourth sections (a2, b2, c2, d2), and among the first to fourth sections (a2, b2, c2, d2), may select the fourth section (d2), which is a section in which the charging state of the second secondary battery is below a predetermined threshold and in which the slope change trend of the first profile (TH2) is different from that of other sections, as the target section.

Then, the processor 120 estimates the capacity ratio of silicon or silicon oxide by comparing the total length (L2) of the plurality of sections (a2, b2, c2, d2) along the first axis (horizontal axis) direction representing time or charging state (SoC) with the length (L2') of the target section along the first axis (horizontal axis) direction.

For example, the capacity ratio CR2 of SiO in FIG. 7 may be calculated as k(L2'/L2) ×100 [%] according to the formula 1.

When the capacity ratio is estimated in this way, the processor 120 diagnoses the state of the second secondary battery using the estimated capacity ratio as described with reference to FIG. 6.

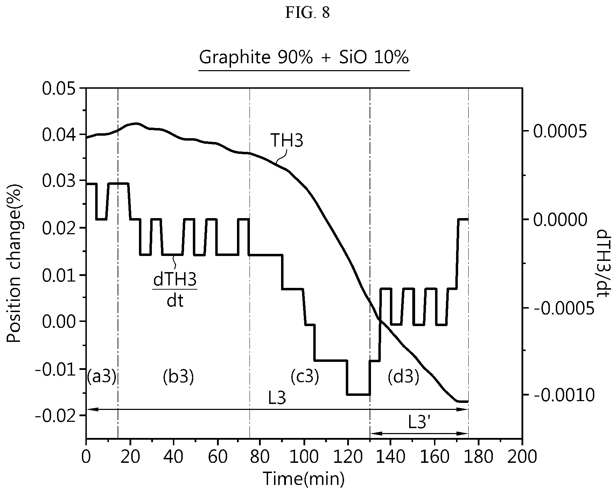

FIG. 8 is a drawing showing the first profile and the second profile of a third secondary battery to which a negative electrode active material containing silicon oxide at a weight ratio of 10% is applied.

In FIG. 8, the horizontal axis represents the time elapsed after the start of the discharging cycle, the left vertical axis represents the ratio of the surface location change value to the original thickness value of the third secondary battery, and the right vertical axis represents the slope of the first profile (TH3). Depending on the embodiment, the horizontal axis may also represent the SoC (State of Charge) of the third secondary battery.

As shown in FIG. 8, the first profile (TH3) of the third secondary battery containing graphite and SiO at weight ratios of 90% and 10%, respectively, represents the thickness of the third secondary battery that changes over time or according to the charging state change of the third secondary battery during the discharging cycle of the third secondary battery.

In addition, the second profile (dTH3/dt) of the third secondary battery represents the slope of the first profile (TH3) that changes over time or according to the charging state change of the third secondary battery. In this case, the second profile (dTH3/dt) may be obtained by differentiating the first profile (TH3) with respect to time (t).

The first profile (TH3) of the third secondary battery shows that the thickness of the third secondary battery gradually decreases during discharge of the third secondary battery.

However, the second profile (dTH3/dt) of the third secondary battery shows that the slope of the first profile (TH3) gradually decreases while the third secondary battery is being discharged, and then increases again at a certain point.

That is, the second profile (dTH3/dt) is divided into a plurality of sections (a3, b3, c3, d3). In this case, the slope of each section gradually decreases as it goes from the first section (a3), which corresponds to the early stage of discharging, to the second section (b3) and the third section (c3), which correspond to the middle stage of discharging, but in the fourth section (d3), which corresponds to the end of discharging, the slope changes to an increasing trend.

Therefore, the processor 120 of the secondary battery diagnosing apparatus 100 according to the present disclosure estimates the capacity ratio of silicon or silicon oxide using the sensing result of the thickness sensor 110 that senses the thickness change of the secondary battery during charging or discharging, as described with reference to FIG. 6, and may diagnose the state of the corresponding secondary battery based on the capacity ratio.

That is, the thickness sensor 110 senses the thickness change of the third secondary battery while the third secondary battery is being discharged.

In addition, the processor 120 generates a first profile (TH3) representing the thickness of the third secondary battery that changes over time or according to the charging state change, and a second profile (dTH3/dt) representing the slope of the first profile (TH3) that changes over time or according to the charging state change of the third secondary battery, using the sensing result of the thickness sensor 110, and estimates the capacity ratio of SiO corresponding to silicon oxide based on the second profile (dTH3/dt).

To this end, the processor 120 divides the second profile (dTH3/dt) into a plurality of sections (a3, b3, c3, d3), and select a target section related to silicon or silicon oxide among these plurality of sections (a3, b3, c3, d3).

For example, the processor 120 may divide the second profile (dTH3/dt) into first to fourth sections (a3, b3, c3, d3), and among the first to fourth sections (a3, b3, c3, d3), may select the fourth section (d3), which is a section in which the charging state of the third secondary battery is below a predetermined threshold and in which the slope change trend of the first profile (TH3) is different from that of other sections, as the target section.

Then, the processor 120 estimates the capacity ratio of silicon or silicon oxide by comparing the total length (L3) of the plurality of sections (a3, b3, c3, d3) along the first axis (horizontal axis) direction representing time or charging state (SoC) with the length (L3') of the target section along the first axis (horizontal axis) direction.

For example, the capacity ratio CR3 of SiO in FIG. 8 may be calculated as k(L3'/L3) ×100 [%] according to the formula 1.

When the capacity ratio is estimated in this way, the processor 120 diagnoses the state of the third secondary battery using the estimated capacity ratio as described with reference to FIG. 6.

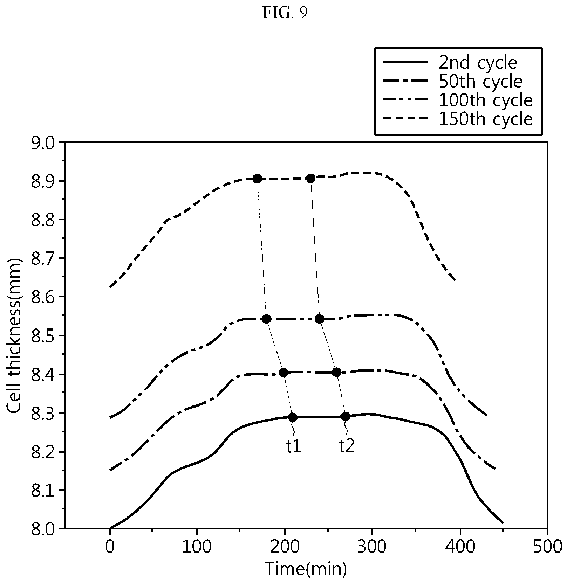

FIG. 9 is a graph showing the thickness change during charging and discharging of a secondary battery according to the number of charging and discharging cycles of the secondary battery.

As illustrated in FIG. 9, as the number of charging and discharging cycles increases, the thickness of the secondary battery gradually increases. In addition, when the pause time between the charging end time (t1) and the discharging start time (t2) is the same in all charging and discharging cycles, the total charging and discharging time gradually decreases as the number of charging and discharging cycles increases.

Therefore, the first profile, which shows the thickness of the secondary battery that changes over time or according to the charging state change, and the second profile, which is obtained by differentiating the first profile with respect to time or SoC, also change according to the number of cycles of the secondary battery, and if the diagnosis target secondary battery is a normal secondary battery, the profiles show similar change patterns according to the number of cycles.

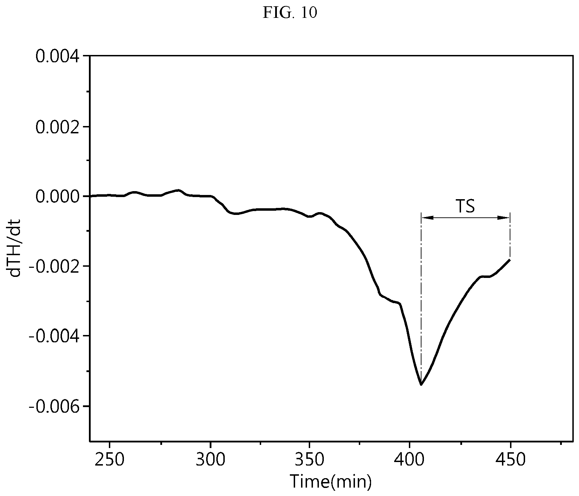

FIG. 10 is a drawing showing the second profile in which the thickness of the secondary battery is differentiated with respect to time during discharging.

As illustrated in FIG. 10, the second profile, which is obtained by differentiating the thickness with respect to time during discharging of a secondary battery to which a negative electrode active material including silicon or silicon oxide is applied, gradually decreases as discharge progresses, and then increases at the target section (TS) at the end of discharging.

The length of the target section (TS) in the horizontal axis direction changes depending on the number of discharging cycles of the secondary battery.

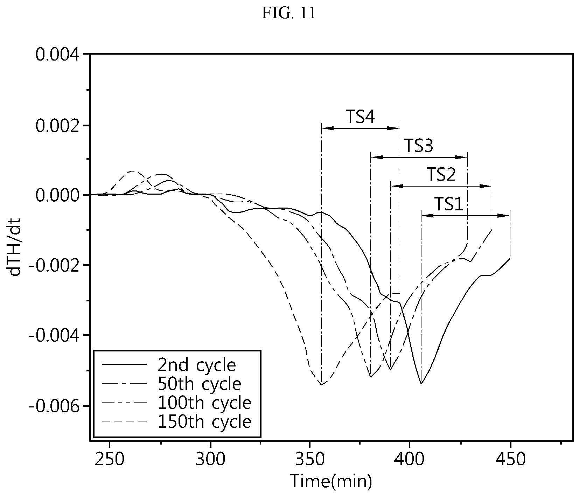

FIG. 11 is a drawing showing the second profile in which the thickness of the secondary battery is differentiated with respect to time during discharging, according to the number of discharging cycles of the corresponding secondary battery.

As illustrated in FIG. 11, the pattern of the second profile and the length of the target section may vary depending on the number of discharging cycles of the secondary battery. That is, as the number of discharging cycles of the secondary battery increases and the secondary battery deteriorates, the pattern of the second profile may show a tendency to shrink gradually. In addition, the position and length of the target section may also change depending on the change in the pattern of the second profile.

For example, when a secondary battery to which a negative electrode active material containing graphite and SiO at weight ratios of 90% and 10%, respectively, is applied is in a normal state, the target section (TS1) of the second profile corresponding to the second discharging cycle may have a length corresponding to a capacity ratio of 25%. In addition, the target sections (TS2, TS3, TS4) of the second profiles corresponding to the 50th, 100th, and 150th discharging cycles, respectively, are lengthened gradually according to the number of discharging cycles and may have a length corresponding to a capacity ratio close to 29.1%.

On the other hand, if the state of the secondary battery is abnormal, such as swelling occurring in the corresponding secondary battery as the discharging cycle is repeated or loss of the conductive pass occurring due to pulverization of SiO, the target sections (TS1, TS2, TS3, TS4) of the second profiles gradually lengthen according to the number of discharging cycles and then suddenly shorten again.

Therefore, the processor 120 of the secondary battery diagnosing apparatus 100 according to the present disclosure may repeatedly estimate the capacity ratio of silicon or silicon oxide included in the negative electrode active material while the charging cycle or discharging cycle of the diagnosis target secondary battery is repeated, and diagnose the state of the diagnosis target secondary battery based on the change trend of the estimated capacity ratios.

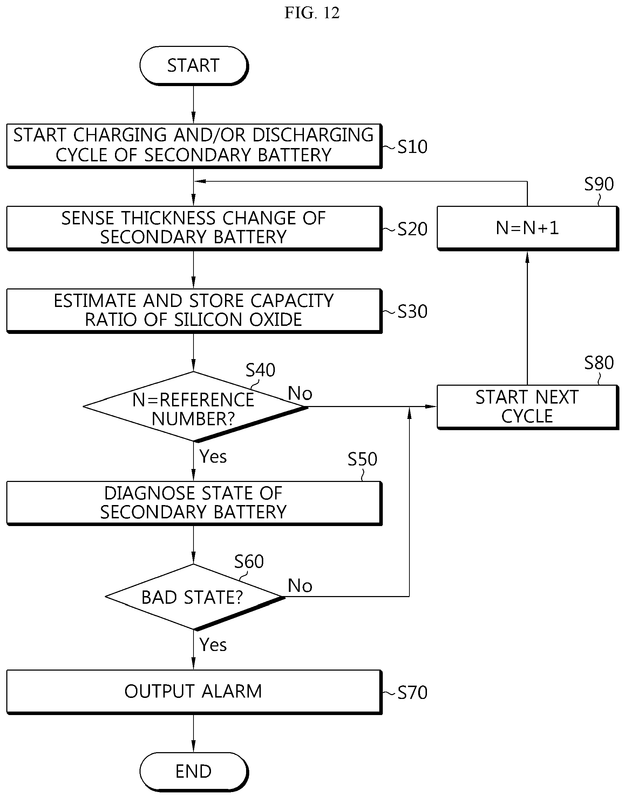

FIG. 12 is a flow chart showing a secondary battery diagnosing method according to an embodiment of the present disclosure.

With reference to FIG. 12, detailed operations of the secondary battery diagnosing apparatus 100 according to the present disclosure may be explained in time series.

When a charging and/or discharging cycle of a secondary battery to which a negative electrode active material containing silicon or silicon oxide is applied is initiated, the thickness sensor 110 of the secondary battery diagnosing apparatus 100 senses a thickness change of the secondary battery according to a volume change of the negative electrode active material while the secondary battery is being charged or discharged (S10, S20).

Next, the processor 120 of the secondary battery diagnosing apparatus 100 estimates a capacity ratio, which is a ratio of the capacity provided by the silicon or the silicon oxide to the capacity of the secondary battery provided by the negative electrode active material, using the sensing result of the thickness sensor 110. In this case, the estimated capacity ratio may be stored in the memory 130 of the secondary battery diagnosing apparatus 100 (S30).

Then, when the number of cycles of the secondary battery reaches a predetermined reference number, the processor 120 may diagnose the state of the secondary battery based on the estimated capacity ratio (S40, S50).

On the other hand, if the number of cycles of the secondary battery does not reach the reference number of cycles, the processor 120 waits without diagnosing the state of the secondary battery, and when the next charging and/or discharging cycle of the secondary battery starts, the processor 120 may repeat the secondary battery thickness sensing process (S20) and the capacity ratio estimation process of silicon or silicon oxide (S40, S80, S90).

In the secondary battery state diagnosis process (S50), if the state of the secondary battery is diagnosed as bad, the processor 120 may control the output device 140 to output a predetermined alarm (S60, S70).

On the other hand, in the secondary battery state diagnosis process (S50), if the state of the secondary battery is diagnosed as not bad, the processor 120 stores the diagnosis result in the memory 130 and then waits, and when the next charging and/or discharging cycle of the secondary battery is initiated, the processor 120 may repeat the above-described processes (S20 to S50) (S60, S80, S90).

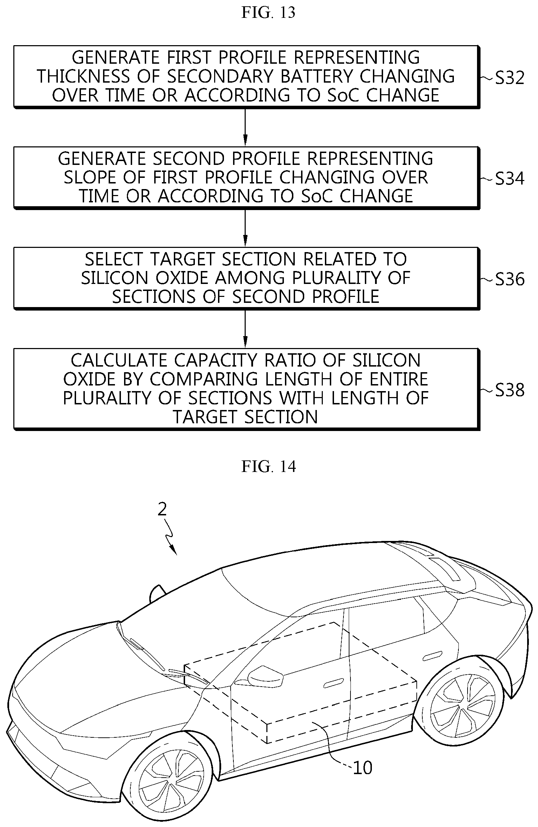

FIG. 13 is a flow chart showing a capacity ratio estimation process of the secondary battery diagnosing method according to an embodiment of the present disclosure.

As illustrated in FIG. 13, when the thickness sensor 110 senses a thickness change of the secondary battery while the secondary battery is being discharged, the processor 120 uses the sensing result of the thickness sensor 110 to generate a first profile representing the thickness of the corresponding secondary battery that changes over time or according to a change in the charging state (SoC) of the corresponding secondary battery (S32).

Then, the processor 120 generates a second profile that represents a slope of the first profile that changes over time or according to a change in the charging state (SoC) of the secondary battery based on the first profile (S34). In this case, the second profile may be obtained by differentiating the first profile with respect to time or SoC.

Then, the processor 120 estimates the capacity ratio of silicon or silicon oxide based on the second profile.

Specifically, the processor 120 divides the second profile into a plurality of sections and select a target section related to the silicon or the silicon oxide among the plurality of sections (S36).

Then, the processor 120 estimates the capacity ratio by comparing the length of the entire plurality of sections along the first axis direction with the length of the target section along the first axis direction (S38).

In this case, the processor 120 divides the second profile into a plurality of sections according to the slope change trend of the first profile shown in the second profile.

In addition, the processor 120 selects a section among the plurality of sections in which the charging state of the secondary battery is less than a predetermined threshold and in which the slope change trend of the first profile is different from that of other sections, as a target section.

Since the first profile is about a thickness change during discharging of the secondary battery, the processor 120 selects a section among a plurality of sections of the second profile in which the slope change trend of the first profile has changed from a decreasing trend to an increasing trend, as the target section.

As described above, when a target section is selected, the processor estimates a capacity ratio of silicon or silicon oxide by comparing the entire length of the plurality of sections along the first axis direction with the length of the target section along the first axis direction. The capacity ratio may be calculated as in the formula 1.

When the capacity ratio is estimated in this way, the processor 120 diagnoses the state of the secondary battery using the estimated capacity ratio. For example, the processor 120 may diagnose the state of the secondary battery by comparing the estimated capacity ratio with a reference capacity ratio of silicon or silicon oxide obtained in advance from a normal secondary battery.

In an embodiment, the secondary battery diagnosing apparatus 100 according to the present disclosure may store reference capacity ratio information of the diagnosis target secondary battery in advance in the memory 130. The reference capacity ratio information may include information indicating a reference capacity ratio corresponding to a predetermined number of charging cycles or a predetermined number of discharging cycles of the diagnosis target secondary battery. In this case, the processor 120 may diagnose the state of the secondary battery by comparing the capacity ratio estimated for the secondary battery with the reference capacity ratio stored in advance in the memory 130.

In another embodiment, before diagnosing the state of the secondary battery, the processor 120 may further estimate a weight ratio, which is a ratio of the weight of silicon or silicon oxide to the total weight of the negative electrode active material, and compare the estimated capacity ratio with a reference capacity ratio corresponding to the weight ratio, thereby diagnosing the state of the secondary battery.

In this case, the processor 120 may estimate the weight ratio before the number of charging cycles or discharging cycles of the diagnosis target secondary battery exceeds a predetermined number.

For example, the processor 120 may estimate a capacity ratio of silicon oxide after the end of the charging cycle or discharging cycle that has been performed before degradation of the diagnosis target secondary battery occurs, and estimate a weight ratio of silicon oxide corresponding to the estimated capacity ratio.

Next, the processor 120 may obtain reference capacity ratio information corresponding to the estimated weight ratio among the reference capacity ratio information for each weight ratio pre-stored in the memory 130.

Afterwards, the processor 120 may diagnose the state of the secondary battery by comparing the obtained reference capacity ratio information with the capacity ratio of silicon or silicon oxide repeatedly estimated in relation to the secondary battery.

FIG. 14 is a drawing showing a vehicle 2 according to an embodiment of the present disclosure.

As illustrated in FIG. 14, the vehicle 2 according to an embodiment of the present disclosure may include the secondary battery diagnosing apparatus according to the present disclosure. The secondary battery diagnosing apparatus may be configured to diagnose a secondary battery of a battery pack 10 mounted in the vehicle 2. In this case, the secondary battery diagnosing apparatus may be configured to interact with an ECU (Electronic Control Unit) of the vehicle 2.

In another embodiment, the secondary battery diagnosing apparatus may be included in the battery pack 10 mounted on the vehicle 2. In this case, the secondary battery diagnosing apparatus may be configured to interact with a BMS (Battery Management System) of the battery pack 10.

For reference, the secondary battery diagnosing apparatus according to the present disclosure may be applied to various electrical devices or electrical systems that use secondary batteries in addition to vehicles, and may also be applied to ESS (Energy Storage System).

As described above, and according to claim 1, while a secondary battery to which a negative electrode active material including silicon or silicon oxide is applied is being charged or discharged, a thickness sensor senses a thickness change of the secondary battery according to a volume change of the negative electrode active material, and a processor estimates a capacity ratio, which is a ratio of an electrical capacity provided by silicon oxide to an electrical capacity provided by the negative electrode active material of the secondary battery, by using the sensing result of the thickness sensor regarding the thickness change of the secondary battery, and diagnoses the state of the secondary battery based on this capacity ratio, thereby efficiently and accurately diagnosing the state of the secondary battery to which a negative electrode active material including silicon or silicon oxide is applied.

In addition, before the processor estimates the capacity ratio, the processor sequentially generates a first profile representing the thickness of the secondary battery that changes over time or according to the charging state change of the secondary battery, and a second profile representing the slope of the first profile that changes over time or according to the charging state change of the secondary battery, using the sensing result of the thickness sensor, and estimates the capacity ratio based on this second profile, thereby diagnosing the state of the secondary battery in a simplified manner independent of electrical factors of the secondary battery.

In addition, the processor divides the second profile into a plurality of sections, selects a target section that exhibits unique characteristics of silicon or silicon oxide from the plurality of sections, and estimates the capacity ratio by comparing the length of the entire plurality of sections along a first axis direction with the length of the target section along the first axis direction, thereby reducing the amount of computation required to diagnose the state of the secondary battery, and as a result, improving the speed of diagnosing the secondary battery.

According to an embodiment, the processor estimates the weight ratio, which is a ratio of the weight of silicon or silicon oxide to the total weight of the negative electrode active material, and compares the capacity ratio with a reference capacity ratio corresponding to the estimated weight ratio to diagnose the state of the secondary battery, thereby diagnosing the state of the target secondary battery even when the weight ratio of silicon or silicon oxide included in the negative electrode active material of the target secondary battery is unknown.

According to an embodiment, since the thickness sensor for sensing the thickness change of the secondary battery is configured to sense the thickness change of the corresponding secondary battery by measuring the distance from a predetermined location to the surface of the secondary battery, it is possible not only to sense the thickness change of the secondary battery for each secondary battery, but also sense the entire thickness change of the secondary battery module by regarding a plurality of secondary batteries stacked in the thickness direction as one secondary battery module. That is, the secondary battery diagnosing apparatus according to the present disclosure may be included in a battery pack or vehicle having a plurality of secondary batteries, and may diagnose the states of the plurality of secondary batteries in units of secondary battery modules.

Furthermore, the embodiments according to the present disclosure may solve various technical problems other than those mentioned in this specification in the corresponding technical field as well as in related technical fields.

The present disclosure has been described with reference to specific embodiments. However, those skilled in the art will clearly understand that various modified embodiments can be implemented within the technical scope of the present disclosure. Therefore, the embodiments disclosed above should be considered from an illustrative rather than a restrictive perspective. In other words, the true technical scope of the present disclosure is indicated by the claims.

### [Explanation of reference signs]

100: secondary battery diagnosing apparatus
110: thickness sensor
120: processor
130: memory
140: output device

## Claims

1. A secondary battery diagnosing apparatus (100) for diagnosing a state of a secondary battery to which a negative electrode active material containing silicon or silicon oxide is applied, the secondary battery diagnosing apparatus (100) comprising:
a thickness sensor (110) configured to sense a thickness change of the secondary battery according to a volume change of the negative electrode active material while the secondary battery is being discharged; and
a processor (120) configured to estimate a capacity ratio, which is a ratio of a capacity provided by the silicon or the silicon oxide to a capacity of the secondary battery provided by the negative electrode active material, using the sensing result of the thickness sensor (110), generate a first profile representing a thickness of the secondary battery that changes over time or according to a charging state change of the secondary battery and a second profile representing a slope of the first profile that changes over time or according to the charging state change of the secondary battery using the sensing result of the thickness sensor (110), divide the second profile into a plurality of sections according to a slope change trend of the first profile shown in the second profile, select a section, in which a charging state of the secondary battery is within a range below a predetermined threshold and in which a slope change trend of the first profile is changed from a decreasing trend to an increasing trend, among the plurality of sections as the target section, and estimate the capacity ratio by comparing a total length of the plurality of sections along a first axis direction with a length of the target section along the first axis direction, and diagnose the state of the secondary battery based on the capacity ratio.

2. The secondary battery diagnosing apparatus (100) according to claim 1,
wherein the thickness sensor (110) is configured to sense the thickness change of the secondary battery by measuring a distance from a predetermined location to a surface of the secondary battery.

3. The secondary battery diagnosing apparatus (100) according to claim 1,
wherein the processor (120) is configured to, before diagnosing the state of the secondary battery, further estimate a weight ratio, which is a ratio of a weight of the silicon or the silicon oxide to a total weight of the negative electrode active material, and compare the capacity ratio with a reference capacity ratio corresponding to the weight ratio to diagnose the state of the secondary battery.

4. The secondary battery diagnosing apparatus (100) according to claim 3,
wherein the processor (120) is configured to estimate the weight ratio before the number of charging cycles or discharging cycles of the secondary battery exceeds a predetermined number.

5. The secondary battery diagnosing apparatus (100) according to claim 1,
wherein the processor (120) is configured to repeatedly estimate the capacity ratio while a charging cycle or a discharging cycle of the secondary battery is repeated, and diagnose the state of the secondary battery based on a change trend of the estimated capacity ratios.

6. The secondary battery diagnosing apparatus (100) according to any one of claims 1 to 5,
wherein secondary battery diagnosing apparatus (100) is configured to diagnose a state of a secondary battery to which a negative electrode active material containing a mixture is applied in which the silicon or the silicon oxide is mixed with graphite.

7. The secondary battery diagnosing apparatus (100) according to any one of claims 1 to 5,
wherein the secondary battery diagnosing apparatus (100) is configured to diagnose a state of a pouch-type secondary battery.

8. A secondary battery diagnosing method for diagnosing a state of a secondary battery to which a negative electrode active material containing silicon or silicon oxide is applied, the secondary battery diagnosing method comprising:
an A step of, by a thickness sensor (110), sensing a thickness change of the secondary battery according to a volume change of the negative electrode active material while the secondary battery is being discharged;
a B step of, by a processor (120), estimating a capacity ratio, which is a ratio of a capacity provided by the silicon or the silicon oxide to a capacity of the secondary battery provided by the negative electrode active material, using the sensing result of the thickness sensor (110), generating a first profile representing a thickness of the secondary battery that changes over time or according to a charging state change of the secondary battery and a second profile representing a slope of the first profile that changes over time or according to the charging state change of the secondary battery using the sensing result of the thickness sensor (110), dividing the second profile into a plurality of sections according to a slope change trend of the first profile shown in the second profile, select a section, in which a charging state of the secondary battery is within a range below a predetermined threshold and in which a slope change trend of the first profile is different from that of other sections, among the plurality of sections as the target section, and estimating the capacity ratio by comparing a total length of the plurality of sections along a first axis direction with a length of the target section along the first axis direction; and
a C step of, by the processor (120), diagnosing the state of the secondary battery based on the capacity ratio.

## Patentansprüche

1. Sekundärbatterie-Diagnosevorrichtung (100) zum Diagnostizieren eines Zustands einer Sekundärbatterie, auf die ein aktives Material einer negativen Elektrode, das Silizium oder Siliziumoxid enthält, angewendet wird, wobei die Sekundärbatterie-Diagnosevorrichtung (100) umfasst:
einen Dickensensor (110), der konfiguriert ist, um eine Dickenänderung der Sekundärbatterie gemäß einer Volumenänderung des aktiven Materials der negativen Elektrode zu erfassen, während die Sekundärbatterie entladen wird; und
einen Prozessor (120), der konfiguriert ist, um ein Kapazitätsverhältnis, das ein Verhältnis einer Kapazität, die durch das Silizium oder das Siliziumoxid bereitgestellt wird, zu einer Kapazität der Sekundärbatterie, die durch das aktive Material der negativen Elektrode bereitgestellt wird, ist, unter Verwendung des Erfassungsergebnisses des Dickensensors (110) zu schätzen, ein erstes Profil, das eine Dicke der Sekundärbatterie darstellt, die sich im Laufe der Zeit oder gemäß einer Ladezustandsänderung der Sekundärbatterie ändert, und ein zweites Profil, das eine Steigung des ersten Profils darstellt, die sich im Laufe der Zeit oder gemäß der Ladezustandsänderung der Sekundärbatterie ändert, unter Verwendung des Erfassungsergebnisses des Dickensensors (110) zu erzeugen, das zweite Profil in eine Vielzahl von Abschnitten gemäß einem Steigungsänderungstrend des ersten Profils, das in dem zweiten Profil gezeigt ist, zu unterteilen, einen Abschnitt, in dem ein Ladezustand der Sekundärbatterie innerhalb eines Bereichs unter einem vorbestimmten Schwellenwert liegt und in dem ein Steigungsänderungstrend des ersten Profils von einem abnehmenden Trend zu einem zunehmenden Trend geändert wird, aus der Vielzahl von Abschnitten als den Zielabschnitt auszuwählen und das Kapazitätsverhältnis durch Vergleichen einer Gesamtlänge der Vielzahl von Abschnitten entlang einer ersten Achsenrichtung mit einer Länge des Zielabschnitts entlang der ersten Achsenrichtung zu schätzen und den Zustand der Sekundärbatterie basierend auf dem Kapazitätsverhältnis zu diagnostizieren.

2. Sekundärbatterie-Diagnosevorrichtung (100) nach Anspruch 1,
wobei der Dickensensor (110) konfiguriert ist, um die Dickenänderung der Sekundärbatterie durch Messen eines Abstands von einer vorbestimmten Stelle zu einer Oberfläche der Sekundärbatterie zu erfassen.

3. Sekundärbatterie-Diagnosevorrichtung (100) nach Anspruch 1,
wobei der Prozessor (120) konfiguriert ist, um vor dem Diagnostizieren des Zustands der Sekundärbatterie ferner ein Gewichtsverhältnis zu schätzen, das ein Verhältnis eines Gewichts des Siliziums oder des Siliziumoxids zu einem Gesamtgewicht des aktiven Materials der negativen Elektrode ist, und das Kapazitätsverhältnis mit einem Referenzkapazitätsverhältnis zu vergleichen, das dem Gewichtsverhältnis entspricht, um den Zustand der Sekundärbatterie zu diagnostizieren.

4. Sekundärbatterie-Diagnosevorrichtung (100) nach Anspruch 3,
wobei der Prozessor (120) konfiguriert ist, um das Gewichtsverhältnis zu schätzen, bevor die Anzahl von Ladezyklen oder Entladezyklen der Sekundärbatterie eine vorbestimmte Anzahl überschreitet.

5. Sekundärbatterie-Diagnosevorrichtung (100) nach Anspruch 1,
wobei der Prozessor (120) konfiguriert ist, um das Kapazitätsverhältnis wiederholt zu schätzen, während ein Ladezyklus oder ein Entladezyklus der Sekundärbatterie wiederholt wird, und den Zustand der Sekundärbatterie basierend auf einem Änderungstrend der geschätzten Kapazitätsverhältnisse zu diagnostizieren.

6. Sekundärbatterie-Diagnosevorrichtung (100) nach einem der Ansprüche 1 bis 5,
wobei die Sekundärbatterie-Diagnosevorrichtung (100) konfiguriert ist, um einen Zustand einer Sekundärbatterie zu diagnostizieren, auf die ein aktives Material einer negativen Elektrode, das eine Mischung enthält, angewendet wird, in der das Silizium oder das Siliziumoxid mit Graphit gemischt ist.

7. Sekundärbatterie-Diagnosevorrichtung (100) nach einem der Ansprüche 1 bis 5,
wobei die Sekundärbatterie-Diagnosevorrichtung (100) konfiguriert ist, um einen Zustand einer Pouch-Sekundärbatterie zu diagnostizieren.

8. Sekundärbatterie-Diagnoseverfahren zum Diagnostizieren eines Zustands einer Sekundärbatterie, auf die ein aktives Material einer negativen Elektrode, das Silizium oder Siliziumoxid enthält, angewendet wird, wobei das Sekundärbatterie-Diagnoseverfahren umfasst:
einen Schritt A des Erfassens, durch einen Dickensensor (110), einer Dickenänderung der Sekundärbatterie gemäß einer Volumenänderung des aktiven Materials der negativen Elektrode, während die Sekundärbatterie entladen wird;
einen Schritt B des Schätzens, durch einen Prozessor (120), eines Kapazitätsverhältnisses, das ein Verhältnis einer Kapazität, die durch das Silizium oder das Siliziumoxid bereitgestellt wird, zu einer Kapazität der Sekundärbatterie, die durch das aktive Material der negativen Elektrode bereitgestellt wird, ist, unter Verwendung des Erfassungsergebnisses des Dickensensors (110), des Erzeugens eines ersten Profils, das eine Dicke der Sekundärbatterie darstellt, die sich im Laufe der Zeit oder gemäß einer Ladezustandsänderung der Sekundärbatterie ändert, und eines zweiten Profils, das eine Steigung des ersten Profils darstellt, die sich im Laufe der Zeit oder gemäß der Ladezustandsänderung der Sekundärbatterie ändert, unter Verwendung des Erfassungsergebnisses des Dickensensors (110), des Unterteilens des zweiten Profils in eine Vielzahl von Abschnitten gemäß einem Steigungsänderungstrend des ersten Profils, das in dem zweiten Profil gezeigt ist, des Auswählens eines Abschnitts, in dem ein Ladezustand der Sekundärbatterie innerhalb eines Bereichs unter einem vorbestimmten Schwellenwert liegt und in dem ein Steigungsänderungstrend des ersten Profils von dem anderer Abschnitte verschieden ist, aus der Vielzahl von Abschnitten als den Zielabschnitt und des Schätzens des Kapazitätsverhältnisses durch Vergleichen einer Gesamtlänge der Vielzahl von Abschnitten entlang einer ersten Achsenrichtung mit einer Länge des Zielabschnitts entlang der ersten Achsenrichtung; und
einen Schritt C des Diagnostizierens, durch den Prozessor (120), des Zustands der Sekundärbatterie basierend auf dem Kapazitätsverhältnis.

## Revendications

1. Appareil de diagnostic de batterie rechargeable (100) pour diagnostiquer un état d'une batterie rechargeable à laquelle un matériau actif d'électrode négative contenant un silicium ou un oxyde de silicium est appliqué, l'appareil de diagnostic de batterie rechargeable (100) comprenant :
un capteur d'épaisseur (110) configuré pour détecter un changement d'épaisseur de la batterie rechargeable en fonction d'un changement de volume du matériau actif d'électrode négative pendant que la batterie rechargeable se décharge ; et
un processeur (120) configuré pour estimer un rapport de capacités, lequel est un rapport d'une capacité fournie par le silicium ou l'oxyde de silicium à une capacité de la batterie rechargeable fournie par un matériau actif d'électrode négative, en utilisant le résultat de détection du capteur d'épaisseur (110), générer un premier profil représentant une épaisseur de la batterie rechargeable qui change dans le temps ou en fonction d'un changement d'état de charge de la batterie rechargeable et un deuxième profil représentant une inclinaison du premier profil qui change dans le temps ou en fonction du changement d'état de charge de la batterie rechargeable en utilisant le résultat de détection du capteur d'épaisseur (110), diviser le deuxième profil en une pluralité de sections en fonction d'une tendance de changement d'inclinaison du premier profil montré dans le deuxième profil, sélectionner une section, dans laquelle un état de charge de la batterie rechargeable est compris dans une plage au-dessous d'un seuil prédéterminé et dans lequel une tendance de changement d'inclinaison du premier profil est changée d'une tendance décroissante à une tendance croissante, parmi la pluralité de sections étant la section cible, et estimer le rapport de capacités en comparant une longueur totale de la pluralité de sections le long d'une direction du premier axe avec une longueur de la section cible le long de la direction du premier axe et diagnostiquer l'état de la batterie rechargeable sur la base du rapport de capacités.

2. Appareil de diagnostic de batterie rechargeable (100) selon la revendication 1,
dans lequel le capteur d'épaisseur (110) est configuré pour détecter le changement d'épaisseur de la batterie rechargeable en mesurant une distance d'un emplacement prédéterminé à une surface de la batterie rechargeable.

3. Appareil de diagnostic de batterie rechargeable (100) selon la revendication 1,
dans lequel le processeur (120) est configuré pour, avant de diagnostiquer l'état de la batterie rechargeable, estimer en outre un rapport de poids, lequel est un rapport d'un poids du silicium ou de l'oxyde de silicium à un poids total du matériau actif d'électrode négative et comparer le rapport de capacités avec un rapport de capacités de référence correspondant au rapport en poids pour diagnostiquer l'état de la batterie rechargeable.

4. Appareil de diagnostic de batterie rechargeable (100) selon la revendication 3,
dans lequel le processeur (120) est configuré pour estimer le rapport de poids avant que le nombre de cycles de charge ou de cycles de décharge de la batterie rechargeable n'excède pas un nombre prédéterminé.

5. Appareil de diagnostic de batterie rechargeable (100) selon la revendication 1,
dans lequel le processeur (120) est configuré pour estimer de manière répétée le rapport de capacités pendant qu'un cycle de charge ou un cycle de décharge de la batterie rechargeable est répété et diagnostiquer l'état de la batterie rechargeable sur la base d'une tendance de changement des rapports de capacités estimés.

6. Appareil de diagnostic de batterie rechargeable (100) selon l'une quelconque des revendications 1 à 5,
dans lequel l'appareil de diagnostic de batterie rechargeable (100) est configuré pour diagnostiquer un état d'une batterie rechargeable à laquelle un matériau actif d'électrode négative contenant un mélange est appliqué dans lequel le silicium ou l'oxyde de silicium est mélangé avec un graphite.

7. Appareil de diagnostic de batterie rechargeable (100) selon l'une quelconque des revendications 1 à 5,
dans lequel l'appareil de diagnostic de batterie rechargeable (100) est configuré pour diagnostiquer un état d'une batterie rechargeable de type poche.

8. Procédé de diagnostic de batterie rechargeable pour diagnostiquer un état d'une batterie rechargeable à laquelle un matériau actif d'électrode négative contenant un silicium ou un oxyde de silicium est appliqué, le procédé de diagnostic de batterie rechargeable comprenant :
une étape A, par un capteur d'épaisseur (110), consistant à détecter un changement d'épaisseur de la batterie rechargeable en fonction d'un changement de volume du matériau actif d'électrode négative pendant que la batterie rechargeable se décharge ;
une étape B, par un processeur (120), consistant à estimer un rapport de capacités, lequel est un rapport d'une capacité fournie par le silicium ou l'oxyde de silicium à une capacité de la batterie rechargeable fournie par le matériau actif d'électrode négative, en utilisant le résultat de détection du capteur d'épaisseur (110), générer un premier profil représentant une épaisseur de la batterie rechargeable qui change dans le temps ou en fonction d'un changement d'état de charge de la batterie rechargeable et un deuxième profil représentant une inclinaison du premier profil qui change dans le temps ou en fonction du changement d'état de charge de la batterie rechargeable utilisant le résultat de détection du capteur d'épaisseur (110), en divisant le deuxième profil en une pluralité de sections en fonction d'une tendance de changement d'inclinaison du premier profil montré dans le deuxième profil, sélectionner une section dans laquelle un état de charge de la batterie rechargeable est compris dans une plage au-dessous d'un seuil prédéterminé et dans laquelle une tendance de changement d'inclinaison du premier profil est différente de celle d'autres sections, parmi la pluralité de sections étant la section cible et estimer le rapport de capacités en comparant une longueur totale de la pluralité de sections le long d'une direction du premier axe avec une longueur de la section cible le long de la direction du premier axe ; et
une étape C, par le processeur (120), consistant à diagnostiquer l'état de la batterie rechargeable sur la base du rapport de capacités.
